# EUROPEAN PATENT APPLICATION

(11) **EP 2 637 214 A1**
(43) Date of publication of application: **11.09.2013**
(21) Application number: 11837750.6
(22) Date of filing: 01.11.2011
(51) Int. Cl.: H01L 31/04

(54) **PHOTOELECTRIC CONVERSION ELEMENT**

(30) Priority: 02.11.2010 JP 2010246311
(71) Applicant: FUJIFILM Corporation, Tokyo 106-8620 (JP)
(72) Inventor: KOBAYASHI, Hiroyuki, Ashigarakami-gun Kanagawa 258-8577 (JP); FUKUNAGA, Toshiaki, Ashigarakami-gun Kanagawa 258-8577 (JP); MURAKAMI, Naoki, Ashigarakami-gun Kanagawa 258-8577 (JP)
(74) Representative: HOFFMANN EITLE
(86) International application number: PCT/JP2011/006123
(87) International publication number: WO 2012/060096

(57) **Abstract**

[Problem to be solved] To provide improved adhesion to a photoelectric conversion device, which includes a photoelectric conversion layer formed through vapor deposition on a conductive layer formed by a transition metal.

[Solution] A photoelectric conversion device (1), which includes, on a substrate (10), a layered structure of a conductive layer (20) formed by a transition metal element, a photoelectric conversion layer (30) formed by a compound semiconductor containing a group Ib element, a group IIIb element and a group Vlb element, and a transparent electrode (60), further includes a transition metal dichalcogenide thin film (25) formed by the transition metal element and the group VIb element between the conductive layer (20) and the photoelectric conversion layer (30). 80% or less of lot of crystallites (25a) forming the transition metal dichalcogenide thin film (25) and occupying the surface of the conductive layer (20), on which the thin film is formed, have the c-axes thereof oriented substantially perpendicular to the surface of the conductive layer (20).

## Description

### BACKGROUND OF THE INVENTION

### Field of the Invention

The present invention relates to a photoelectric conversion device, which is used in solar batteries, CCD sensors, etc.

### Description of the Related Art

Photoelectric conversion devices, which include a photoelectric conversion layer and electrodes electrically connected to the photoelectric conversion layer, are used in applications such as solar batteries. The main streamof conventional solar batteries has been Si solar batteries, which use bulk single-crystal Si or polycrystal Si, or thin-film amorphous Si. On the other hand, compound semiconductor solar batteries, which do not depend on Si, are now being researched and developed. As the compound semiconductor solar batteries, those of a bulk type, such as GaAs solar batteries, etc., and those of a thin-film type, such as CIGS solar batteries, which contain a group Ib element, a group IIIb element and a group VIb element, are known. CIGS is a compound semiconductor represented by the general formula below:
Cu_{1-z}In₁₋ₓGaₓSe_{2-y}S_{y} (where 0 ≤ x ≤ 1, 0 ≤ y ≤ 2, 0 ≤ z ≤ 1),
and it is CIS when x = 0 or CIGS when x > 0. It should be noted that the "CIGS" herein also includes CIS.

For the production of CIGS photoelectric conversion devices, the problem of delamination between layers of the layered structure is important. In particular, in the case where roll-to-roll processing is used for the production, the formed films are more likely to delaminate due to a load imposed on the formed films during conveyance. Reduction of the delamination contributes to improved production yield and improved photoelectric conversion efficiency.

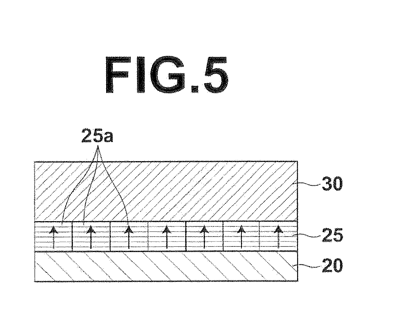

The main cause of the delamination in CIGS photoelectric conversion devices is said to be that a laminar MoSe₂ layer, which is c-axis orientated relative to a back electrode layer (see FIG. 5), is formed at the interface between the CIGS serving as the photoelectric conversion layer and a Mo layer serving as the back electrode.

It is stated in Non-patent Document 1 that the interlayer coupling of the laminar MoSe₂ layer is a weak coupling by the van der Waals force, and therefore the adhesion of the Mo layer with the laminar MoSe₂ layer formed thereon to the CIGS film is weakened.

In order to reduce the delamination, methods for inhibiting formation of the MoSe₂ layer are discussed, for example, in Patent Documents 1, 2 and 3.

Patent Documents 1 to 3 disclose methods for inhibiting the MoSe₂ layer in a case where the CIGS layer is formed by selenation.

On the other hand, it is reported that the presence of the MoSe₂ layer between the Mo layer and the CIGS layer forms ohmic contact between the Mo layer and the MoSe₂ layer, and this contributes to improved efficiency of a solar battery. Further, it is proposed to form a semiconductor layer, such as ZnO, on the Mo layer, in place of the MoSe₂ layer, to improve the conversion efficiency (see Patent Documents 4 and 5, for example).

### Patent Documents

Patent Document 1: Japanese Unexamined Patent Publication No. 6-188444
Patent Document 2: Japanese Unexamined Patent Publication No. 9-321326
Patent Document 3: Japanese Unexamined Patent Publication No. 2009-289955
Patent Document 4: Japanese Unexamined Patent Publication No. 2006-013028
Patent Document 5: Japanese Unexamined Patent Publication No. 2007-335625

### Non-patent Document

Non-patent Document 1: D. Abou-Ras et al., "Formation and characterization of MoSe2 for Cu (In, Ga) Se2 based solar cells", Thin Solid Films, Vols. 480-481, pp.433-438, 2005

### SUMMARY OF THE INVENTION

However, a method for inhibiting the MoSe₂ layer in a case where the CIGS layer is formed through vapor deposition on a back electrode made of a transition metal has not yet been established, and it is an important problem to inhibit delamination in photoelectric conversion devices where the CIGS layer is formed through vapor deposition.

It should be noted that the same problem occurs in a case where the back electrode is formed by a transition metal other than Mo and the photoelectric conversion layer is formed by a Ib-IIIb-VIb compound semiconductor, due to a transition metal dichalcogenide layer formed between the back electrode and the photoelectric conversion layer.

In view of the above-described circumstances, the present invention is directed to providing a photoelectric conversion device with high adhesion, which is less likely to delaminate.

A photoelectric conversion device includes, on a substrate, a layered structure of a conductive layer formed by a transition metal element, a photoelectric conversion layer formed by a compound semiconductor containing a group Ib element, a group IIIb element and a group VIb element, and a transparent electrode, the photoelectric conversion device further includes:
a transition metal dichalcogenide thin film formed by the transition metal element and the group VIb element between the conductive layer and the photoelectric conversion layer,
wherein the transition metal dichalcogenide thin film includes a lot of crystallites, and 80% or less of the lot of crystallites occupying the surface of the conductive layer, on which the thin film is formed, have c-axes thereof oriented substantially perpendicular to a surface of the conductive layer.

The ratio of the crystallites occupying the surface of the conductive layer and having the c-axes thereof oriented substantially perpendicular to the surface of the conductive layer is a value calculated as follows:
1) A TEM image of a cross section of the layered films perpendicular to the substrate surface (in particular, the photoelectric conversion layer-back electrode interface area) is taken by transmission electron microscopy (TEM) . This image is used as the original image.
2) Utilizing the fact that the photoelectric conversion layer, the transition metal dichalcogenide thin film and the conductive layer are shown at different contrast levels in the TEM image, and using a contrast adjusting function of an image processing software, binarization with a predetermined threshold is performed, and then extraction is performed using an edge extraction function of the image processing software. At this time, the threshold is set such that noise is removed as much as possible and only an area clearly distinguished as the transition metal dichalcogenide thin film is extracted, i.e., only an area in the binarized image clearly distinguished as the transition metal dichalcogenide thin film is extracted. If the contour of the transition metal dichalcogenide thin film in the binarized image is blurred, a contour line is empirically drawn, with viewing the binarized image.
3) An area of the extracted image of the particulates (crystallites) of the transition metal dichalcogenide is calculated from the number of pixels on the image processing software. The number of pixels of each particulate present in the field of view is calculated, and the ratio of crystallites with the c-axes thereof oriented in a substantially perpendicular direction relative to the whole area is calculated.

The observation of the sample, of which the TEM image is taken at 1), is performed with a magnification of 2, 000, 000x. The field of view is at least 100 nm × 100 nm.

The sample is machined to have a uniform thickness of 100 nm or less in the depth direction (the direction perpendicular to the observed cross section) . During the measurement, the electron beam is incident in the direction perpendicular to the substrate surface. As the image processing software, PhotoShop® may be used, for example.

It should be noted that, in this specification, an orientation state where 80% or less of the crystallites occupying the surface of the conductive layer have the c-axes thereof oriented in a substantially perpendicular direction is regarded as a random orientation, which is not preferentially oriented.

It is preferable that the conductive layer is formed by an oriented polycrystalline thin film having a specific crystal plane at the surface thereof, and a plane spacing in the film thickness direction is not greater than a plane spacing of a bulk crystal.

It is particularly preferable that the specific crystal plane is (110); however, the specific crystal plane may be (100) or (111).

The conductive layer may be formed by a thin film with at least part of the surface layer thereof including unoriented crystallites.

At least part of the surface layer of the conductive layer may be oxidized or nitrided.

It is preferable that the transition metal element is Mo.

As the elements forming the photoelectric conversion layer, it is particularly preferable that the group Ib element is Cu, the group IIIb element is at least one selected from the group consisting of Al, Ga and In, and the group VIb element is Se.

It is preferable that the transition metal dichalcogenide thin film is a MoSe₂ thin film.

It is preferable that the substrate is an anodized substrate selected from the group consisting of an anodized substrate including an Al₂O₃ anodized film formed on at least one side of an Al base material, an anodized substrate including an Al₂O₃ anodized film formed on at least one side of a composite base material formed by an Al material combined on at least one side of a Fe material, and an anodized substrate including an Al₂O₃ anodized film formed on at least one side of a base material formed by an Al film formed on at least one side of a Fe material.

The photoelectric conversion device of the invention includes the transition metal dichalcogenide thin film, which includes a lot of crystallites, between the conductive layer and the photoelectric conversion layer, and 80% or less of the lot of crystallites occupying the surface of the conductive layer, on which the thin film is formed, have c-axes thereof oriented substantially perpendicular to a surface of the conductive layer. Therefore, higher adhesion and higher delamination inhibiting effect are provided when compared to a conventional device having a uniform laminar transition metal dichalcogenide thin film, which is typified by a MoSe₂ layer, formed on the back electrode (conductive layer).

The improvement of adhesion leads to improvement of yield, and also leads to improvement of conversion efficiency as a module by reduction of defects due to low adhesion.

### BRIEF DESCRIPTION OF THE DRAWINGS

FIG. 1A is a sectional view illustrating the schematic structure of a photoelectric conversion device according to an embodiment of the present invention,
FIG. 1B is an enlarged sectional view showing a part of the photoelectric conversion device shown in FIG. 1A,
FIG. 2 is a schematic sectional view showing specific examples of a substrate of the photoelectric conversion device,
FIG. 3 is a TEM image of an interface between a photoelectric conversion layer and a back electrode layer of a photoelectric conversion device of an example of the invention,
FIG. 4 is a TEM image of an interface between a photoelectric conversion layer and a back electrode layer of a photoelectric conversion device of a comparative example, and
FIG. 5 is an enlarged sectional view showing a part of a conventional photoelectric conversion device.

### DESCRIPTION OF THE PREFERRED EMBODIMENTS

Hereinafter, a photoelectric conversion device according to an embodiment of the present invention will be described with reference to the drawings.

### Photoelectric conversion device

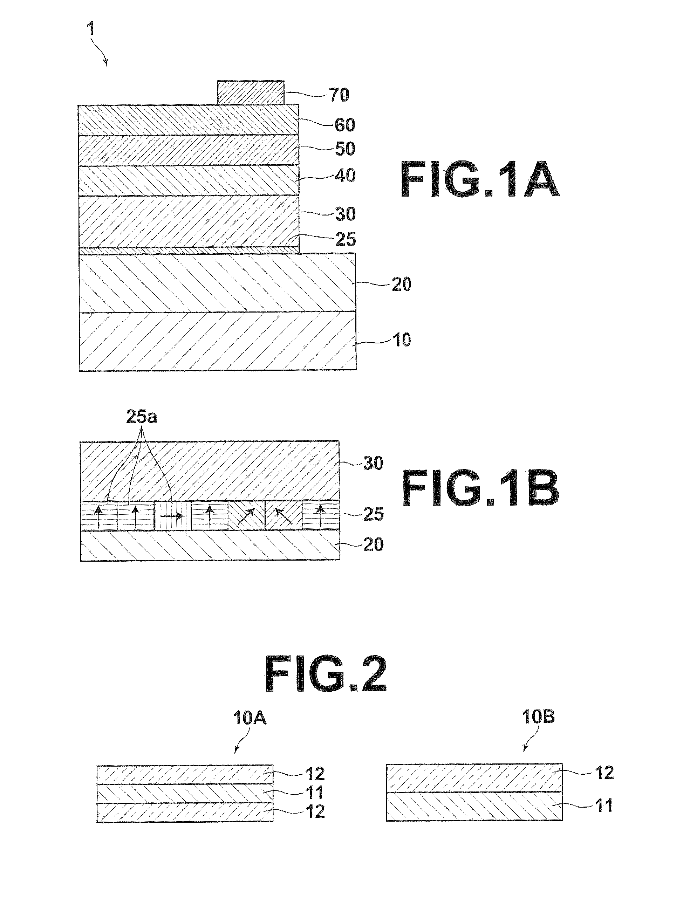

FIG. 1A is a sectional view illustrating the schematic structure of a photoelectric conversion device 1 of this embodiment, and FIG. 1B is an enlarged sectional view schematically illustrating a part of the photoelectric conversion device 1 shown in FIG. 1A. For ease of visual recognition, elements shown in the drawings are not to scale.

As shown in FIG. 1A, the photoelectric conversion device 1 includes, on a substrate 10, a conductive layer 20 mainly composed of a transition metal element and functioning as a back electrode, a photoelectric conversion layer 30, a buffer layer 40, a window layer 50, a transparent electrode (transparent conductive layer) 60 and an extraction electrode (grid electrode) 70, which are formed in layers, and also includes a transition metal dichalcogenide thin film 25 formed by a transition metal element and a group VIb element between the conductive layer 20 and the photoelectric conversion layer 30. It should be noted that the photoelectric conversion layer is formed through vapor deposition.

An shown in the enlarged view of the conductive layer 20, the transition metal dichalcogenide thin film 25 and the photoelectric conversion layer 30 shown in FIG. 1B, the transition metal dichalcogenide thin film 25 is a polycrystalline film including a lot of crystallites 25a, and is characterized by that 80% or less of the lot of crystallites 25a occupying the surface of the conductive layer 20, on which the thin film is formed, have the c-axes thereof oriented substantially perpendicular to the surface of the conductive layer 20. The arrows shown on the crystallites 25a in FIG. 1B represent the c-axis directions.

In the photoelectric conversion device 1 of the invention shown in FIG. 1B, the crystallites 25a with the c-axes thereof substantially perpendicular to the surface of the conductive layer 20 and the crystallites 25a with the c-axes thereof oriented in the other directions are formed in an random arrangement.

The description "80% or less of the lot of crystallites 25a occupying the surface of the conductive layer 20, on which the thin film is formed, have the c-axes thereof oriented substantially perpendicular to the surface of the conductive layer 20" means that 80% or less of the number of the crystallites formed on the surface of the conductive layer 20 have the c-axes perpendicular to the surface. Although the size of the crystallites is not uniform, it is assumed herein that all the crystallites have a uniform average size. It is more preferable that 60% or less of the number of the crystallites formed on the surface of the conductive layer 20 have the c-axes perpendicular to the surface.

FIG. 5 is a sectional view schematically illustrating the structure of a conductive layer 20, a transitionmetal dichalcogenide thin film 25 and a photoelectric conversion layer 30 of a conventional photoelectric conversion device, which has the photoelectric conversion layer formed through a conventional vapor deposition process. As shown in FIG. 5, conventionally, the crystallites 25a in the transition metal dichalcogenide thin film 25 are formed with the c-axes thereof are oriented in a substantially perpendicular direction on the conductive layer 20 serving as the substrate. Since the c-axes of the crystallites 25a are oriented to be substantially perpendicular to the surface of the conductive layer 20, the transitionmetal dichalcogenide thin film 25 formed on the conductive layer 20 is a laminar film, which is likely to delaminate.

It should be noted that, in the case where the c-axes of the crystallites are oriented to be substantially perpendicular to the surface of the conductive layer almost across the entire area thereof, as shown in FIG. 5, the adhesion is very poor and the possibility of delamination is high. In contrast, it is believed that, in the case where the crystallites are randomly oriented, as shown in FIG. 1B, and the degree of preferred orientation of the crystallites is lower than that in the case shown in FIG. 5, more particularly, in the case where about 20% or more of the crystallites are formed with the c-axes thereof oriented in directions different from the direction substantially perpendicular to the surface, the delamination is remarkably inhibited when compared to the case where the crystallites are formed in the laminar form across the entire area.

The following methods may be used to form the transition metal dichalcogenide thin film with the c-axes of the crystallites being not uniformly oriented in the direction perpendicular to the conductive layer.

The first method involves forming the conductive layer 20 as an oriented polycrystalline thin film having a specific crystal plane at the surface thereof, where a plane spacing in the film thickness direction is not greater than a plane spacing of a bulk crystal. The specific crystal plane may be (111), (100), (110), or the like.

In particular, it is more preferable that the plane spacing is smaller than the plane spacing of a bulk crystal, namely, a tensile stress is applied on the crystals of the conductive layer.

The stress depends on a sputtering pressure during formation of the conductive layer and can be changed. If the sputtering pressure is large, the applied stress causes the film to be upwardly convex, i.e., the film is in a pulled state, and therefore the lattice is pulled so that the plane spacing in the film thickness direction is narrowed. It is believed that the smaller plane spacing decreases penetration of the group VIb element into the crystal lattice of the conductive layer, thereby inhibiting formation of the laminar transition metal dichalcogenide layer.

The second method involves forming the conductive layer 20 as a thin film, where at least part of the surface layer thereof includes unoriented crystallites. It should be noted that the surface layer may be formed by a lot of unoriented crystallites, or may be an amorphous surface layer. To evaluate the degree of orientation of the surface of the thin film, an x-ray diffraction parallel beam thin film measurement method may be used. This allows evaluating the crystal structure in the vicinity of the surface of the thin film. In the case where the degree of orientation of the surface of the thin film is evaluated using this method, the surface of the thin film is regarded as "unoriented" when the degree of orientation relative to a certain plane direction according to the Lotgering's method is 80% or less. When the photoelectric conversion layer is formed on the thus formed conductive layer, formation of a laminar transition metal dichalcogenide is inhibited.

It should be noted that, in general, when the conductive layer is formed by sputtering, a (110) -oriented conductive layer is formed. Therefore, it is preferable to provide an orientation control layer for controlling the orientation of the conductive layer 20 under the conductive layer.

As the orientation control layer, a layer made of Cr or Fe may be used, and a Cr layer is more preferable.

The third method involves oxidizing or nitriding at least part of the surface layer of the conductive layer 20. After the formation of the conductive layer 20, the surface of the conductive layer is subjected to an oxygen plasma treatment or a nitrogen plasma treatment, thereby oxidizing or nitriding the surface layer. When the conductive layer formed by a transition metal contains 10 at.% or less of nitrogen or oxygen, the orientation of the conductive layer which is not the uniaxial orientation can be achieved. (The uniaxial orientation refers to a state where the planes are oriented in the film thickness direction, while the in-plane directions are randomly oriented. The uniaxial orientation herein is defined as a case where the degree of orientation in the film thickness direction is 90% or more.) It should be noted that, if the transition metal contains 10 at.% or more of nitrogen or oxygen, crystals of nitride or oxide of the transition metal form, and this even inhibits the growth of the transition metal dichalcogenide.

The fourth method involves adjusting the film formation conditions for forming the photoelectric conversion layer. The transition metal dichalcogenide forms during the formation of the photoelectric conversion layer. Therefore, the substrate temperature, the deposition rate and the element species of the deposition source for vapor deposition of the photoelectric conversion layer are adjusted. Specifically, a low initial substrate temperature (at the initial stage of vapor deposition) may be provided. By providing the low substrate temperature only at the initial stage of film formation, the photoelectric conversion layer is formed on the transition metal in a state where reaction between the transition metal and the chalcogen is not likely to occur. Thereafter, the photoelectric conversion layer serves to inhibit the reaction between the chalcogen and the transition metal. By providing the state where the reaction between the chalcogen and the transition metal is inhibited (i.e., a state where the reaction speed is low), the axial orientation of the transition metal dichalcogenide can be inhibited.

In general, in a conductive layer made of a transition metal formed by sputtering on a substrate, columnar crystals of the transition metal tend to form, and a laminar transition metal dichalcogenide thin film layer is formed on the surfaces of the columnar crystals. It is therefore believed that the orientation state of the transition metal dichalcogenide thin film formed on the surface of the conductive layer can be changed by changing the condition of the surface of the conductive layer, as in the first to third methods.

On the other hand, it is believed that, by adjusting the film formation conditions for forming the photoelectric conversion layer, as in the fourth method, conditions of reaction between the transition metal element forming the conductive layer and the group VIb element can be changed, and this can change the orientation state of the transition metal dichalcogenide thin film.

As previously described, a laminar transition metal dichalcogenide thin film uniformly formed on the back electrode decreases adhesion in the photoelectric conversion device. Therefore, an effect of inhibiting the decrease of adhesion can be provided when the crystallites forming the transition metal dichalcogenide thin film are randomly oriented.

It may be contemplated to inhibit the formation of the transition metal dichalcogenide thin film to inhibit the decrease of adhesion. However, since the MoSe₂ layer contributes to improving the photoelectric conversion efficiency by providing ohmic contact, as previously described, the device of the invention including the transition metal dichalcogenide thin film with controlled orientation can inhibit the delamination and improve the photoelectric conversion efficiency, and this is more preferable than inhibiting the formation of the transition metal dichalcogenide thin film.

Now, the individual layers forming the photoelectric conversion device 1, other than the above-described transition metal dichalcogenide thin film 25, are described in detail.

### Substrate

FIG. 2 is a schematic sectional view of substrates 10A and 10B, which are specific embodiments of the substrate 10. The substrates 10A and 10B are provided by anodizing at least one side of a substrate 11. The substrate 11 is preferably an Al substrate mainly composed of Al, a composite substrate including an Al material mainly composed of Il combined on at least one side of a Fe material mainly composed of Fe (such as SUS), or a substrate including an Al film mainly composed of Al formed on at least one side of a Fe material mainly composed of Fe.

The substrate 10A, as shown on the left in FIG. 2, includes anodized films 12 formed on opposite sides of the substrate 11, and the substrate 10B, as shown on the right in FIG. 2, includes an anodized film 12 formed on one side of the substrate 11. The anodized film 12 is a film mainly composed of Al₂O₃. In view of inhibiting warping of the substrate due to a difference of coefficient of thermal expansion between Al and Al₂O₃ and delamination of the film due to the warping during a device production process, the substrate 10 including the anodized films 12 formed on the opposite sides of the substrate 11, as shown on the left in FIG. 2, is more preferred.

The anodization can be achieved by a known method involving immersing the substrate 11, which has been subjected to treatments such as washing, polishing and smoothing, as necessary, and serves as an anode, with a cathode in an electrolyte, and applying a voltage between the anode and the cathode.

The thicknesses of the substrate 11 and the anodized film 12 are not particularly limited. In view of mechanical strength and reduction of the thickness and weight of the substrate 10, the thickness of the substrate 11 before anodization may preferably be in the range from 0.05 to 0.6 mm, or may more preferably be in the range from 0.1 to 0.3 mm, for example. In view of insulation, mechanical strength, and reduction of the thickness and weight of the substrate, the thickness of the anodized film 12 may preferably be in the range from 0.1 to 100 µm, for example.

Further, the substrate 10 may include a soda-lime glass (SLG) layer on the anodized film 12. The soda-lime glass layer serves to diffuse Na into the photoelectric conversion layer. When the photoelectric conversion layer contains Na, the photoelectric conversion efficiency is further improved.

### Conductive layer (back electrode)

An element forming the conductive layer 20 is not particularly limited, as long as it is a transition metal usable as an electrode; however, it may preferably be Mo, Cr, W or a combination thereof, and may particularly preferably be Mo. The thickness of the conductive layer 20 is not particularly limited; however, it may preferably be in the range from about 200 to 1000 nm.

### Photoelectric Conversion Layer

The main component of the photoelectric conversion layer 30 is at least one compound semiconductor formed by a group Ib element, a group IIIb element and a group VIb element.

Specifically, at least one compound semiconductor formed by:
at least one group Ib element selected from the group consisting of Cu and Ag;
at least one group IIIb element selected from the group consisting of Al, Ga and In; and
at least one group VIb element selected from the group consisting of S, Se, and Te is preferred.

Examples of the compound semiconductor include:
CuAlS₂, CuGaS₂, CuInS₂,
CuAlSe₂, CuGaSe₂,
AgAlS₂, AgGaS₂, AgInS₂,
AgAlSe₂, AgGaSe₂, AgInSe₂,
AgAlTe₂, AgGaTe₂, AgInTe₂,
Cu(In,Al)Se₂, Cu(In,Ga) (S,Se)₂,
Cu_{1-z}In₁₋ₓGaₓSe_{2-y}S_{y} (wherein 0≤x≤1, 0≤y≤2, 0≤z≤1) (CI(G)S),
Ag(In,Ga)Se₂, and Ag(In,Ga) (S,Se)₂.
In particular, CuInGaSe₂ is preferred.

The thickness of the photoelectric conversion layer 30 is not particularly limited; however, it may preferably be in the range from 1.0 to 3.0 µm, or may particularly preferably be in the range from 1.5 to 2.5 µm.

### Buffer Layer

The buffer layer 40 is formed by a layer mainly composed of CdS, ZnS, Zn(S,O) or Zn(S,O,OH) . The thickness of the buffer layer 40 is not particularly limited; however, it may preferably be in the range from 10 nm to 500 nm, or may more preferably be in the range from 15 to 200 nm.

### Window Layer

The window layer 50 is an intermediate layer for taking in light. The composition of the window layer 50 is not particularly limited; however, it may preferably be i-ZnO, or the like. The thickness of the window layer 50 is not particularly limited; however, it may preferably be in the range from 15 to 200 nm. The window layer is optional, i.e., the photoelectric conversion device may not include the window layer 50.

### Transparent electrode

The transparent electrode 60 is a layer for taking in light and functioning as an electrode. The composition of the transparent electrode 60 is not particularly limited; however, it may preferably be n-ZnO, such as ZnO:Al. The thickness of the transparent layer 60 is not particularly limited; however, it may preferably be in the range from 50 nm to 2 µm.

### Extraction electrode

The extraction electrode 70 is an electrode for efficiently extracting electric power generated between the back electrode 20 and the transparent electrode 60.

The main component of the extraction electrode 70 is not particularly limited; however, it may be Al, or the like. The thickness of the extraction electrode 70 is not particularly limited; however, it may preferably be in the range from 0.1 to 3 µm.

The photoelectric conversion device 1 is preferably usable as a solar battery.

A solar battery can be formed, for example, by integrating a lot of above-described photoelectric conversion devices 1, and attaching a cover glass, a protective film, etc., to the integrated photoelectric conversion devices 1, as necessary. It should be noted that it is not necessary to provide the extraction electrode for each cell of the solar battery formed by integrating the lot of photoelectric conversion devices (cells). The integrated solar battery may be formed, for example, through the step of forming the individual layers on the substrate by roll-to-roll processing using a flexible long substrate, the step of forming the photoelectric conversion device including a patterning (scribing) process for integration, the step of cutting the substrate with the devices formed thereon into individual modules, etc. It should be noted that, in the case where the devices are produced using the roll-to-roll processing, the problem of delamination between the conductive layer and the photoelectric conversion layer is more significant due to the scribing process and winding of the substrate in each step. Therefore, the photoelectric conversion device of the invention with high adhesion between the conductive layer and the photoelectric conversion layer is highly effective.

The photoelectric conversion device produced according to a production method of the invention is applicable not only to solar batteries but also to other applications, such as CCDs.

### Method of producing photoelectric conversion device

A method of producing the above-described photoelectric conversion device is briefly described.

First, the substrate 10 is prepared, and the conductive layer 20 is formed on the substrate 10.

The conductive layer 20 is formed by sputtering. For example, Mo is used as the transition metal to form a Mo layer (transition metal layer) on the substrate 10 by sputtering. At this time, a sputtering pressure higher than a conventional sputtering pressure is provided during the sputtering of the Mo layer, so as not to uniformly orient the c-axes of the crystallites of the transition metal dichalcogenide thin film in the direction perpendicular to the conductive layer during the subsequent formation of the photoelectric conversion layer 30. The conventional sputtering pressure is around 0.3 Pa. By providing a sputtering pressure of 0.5 Pa or more (for example, 1.0 Pa), the film formation can be performed with applying a tensile stress to the film. Thus, a smaller plane spacing in the film thickness direction of the Mo film than a plane spacing of a bulk crystal can be provided (a plane spacing in the film thickness direction smaller than plane spacings in the other directions can be provided).

Then, the photoelectric conversion layer 30 formed by a group Ib element, a group IIIb element and a group VIb element is formed on the conductive layer 20 by vapor deposition. In this example, a CuInGaSe layer is formed.

As the vapor deposition process, a multi-source co-evaporation process is particularly preferred among others. As representative processes thereof, a three-stage process (J.R. Tuttle et. al., Mat. Res. Soc. Symp. Proc., Vol. 426, pp. 143-151, 1996, etc.), and a co-evaporation process of the EC Group (L. Stolt et al., 13th EUROPEAN PHOTOVOLTAIC SOLAR ENERGY CONFERENCE, pp. 1451-1455, 1995, etc.) are known.

In the three-step process, first, In, Ga and Se are co-evaporated at a substrate temperature of 400°C in high vacuum, then, the temperature is raised to 500-560°C and Cu and Se are co-evaporated, and then, In, Ga and Se are co-evaporated again. This process provides a graded-bandgap CIGS film with graded bandgap. The process of the EC Group is an improved process of the bilayer process developed by the Boeing Company to deposit Cu-excess CIGS at the early stage of vapor deposition and deposit In-excess CIGS at the later stage of vapor deposition, and can be applied to an in-line process. The bilayer process is described in W.E. Devaney et al., IEEE Transactions on Electron Devices, Vol. 37, pp. 428-433, 1990.

Both the three-stage process and the co-evaporation process of the EC Group provide a Cu-excess CIGS film composition in the process of film growth, and use liquid phase sintering using phase separated liquid phase Cu₂₋ₓSe (x=0∼1). Therefore, large particle size is provided, and a CIGS film with good crystal property is advantageously formed. Further, in recent years, various methods in addition to these methods are examined to improve the crystal property of the CIGS film, and such methods may also be used.

As improved methods for improving the crystal property of the CIGS layer, the following methods are known, for example:
(a) a method using ionized Ga (H. Miyazaki et al., physica status solidl(a), Vol. 203, Issue 11, pp. 2603-2608, 2006, etc);
(b) a method using cracked Se (Proceedings of the 68th Autumn Meeting of the Japan Society of Applied Physics, p. 1491, 7p-L-6, 2007, etc.);
(c) a method using radicalized Se (Proceedings of the 54th Spring Meeting of the Japan Society of Applied Physics, p. 1537, 29p-ZW-10, 2007, etc.); and
(d) a method using a photoexcitation process (Proceedings of the 54th Spring Meeting of the Japan Society of Applied Physics, p. 1538, 29p-ZW-14, 2007, etc.)

During the formation of the photoelectric conversion layer, Se, which is the VIb element of the CIGS layer, reacts with Mo to form the MoSe₂ layer 25.

After the formation of the photoelectric conversion layer 30, the buffer layer 40 is formed on the photoelectric conversion layer 30. The buffer layer 40 may be formed, for example, by CdS through CBD (chemical bath deposition), or the like.

Then, a ZnO layer, for example, is formed as the window layer 50 on the surface of the CdS buffer layer 40, and an Al-ZnO layer, for example, is further formed as the transparent electrode 60 through sputtering.

Finally, an Al layer, for example, is formed as the extraction electrode 70 on the surface of the transparent electrode 60 through vapor deposition to provide the photoelectric conversion device 1.

In the case where a flexible substrate is used as the substrate, it is preferable that the individual steps, such as the step of forming the conductive layer and the step of forming the photoelectric conversion layer, use so-called roll-to-roll processing, which uses a feed roll (unwinding roll) having a long flexible substrate wound as a roll thereon and a take-up roll for taking up the substrate with the films formed thereon as a roll.

### EXAMPLES

Samples of photoelectric conversion devices of an example of the invention and a comparative example were produced. Then, the interface of each sample was observed and an adhesion test (cross cut test) was performed.

### Example

The sample of the example of the photoelectric conversion device of the invention was produced by the following method.

First, a soda-lime glass substrate of 3 cm × 3 cm × 1.1 mmt was prepared and subjected to ultrasonic cleaning for five minutes using each of acetone, ethanol and pure water.

Then, the substrate was introduced in a sputtering device to form a Mo film on the substrate through RF sputtering under the conditions of RF power of 800 W, Ar gas pressure of 1.0 Pa, and substrate temperature of room temperature. Film formation time was adjusted to provide a film thickness of about 600 nm.

Then, 2 µm-thick Cu(In_{0.7}Ga_{0.3})Se₂ was formed as the photoelectric conversion layer (semiconductor layer) on the back electrode through the so-called three-stage process. Substrate temperature at the second and third stages in the three-stage process was 550°C. K-cell (knudsen-Cell) was used as the evaporation source.

Then, a 50 nm-thick CdS buffer layer was formed on the surface of the photoelectric conversion layer (CIGS layer) through CBD (chemical bath deposition).

Then, a 50 nm-thick ZnO layer was formed as the window layer on the surface of the CdS buffer layer through sputtering.

Further, a 300 nm-thick Al-ZnO layer was formed as the transparent electrode through sputtering.

Finally, an Al layer was formed as the extraction electrode on the surface of the Al-ZnO layer through vapor deposition.

### Comparative example

The sample of the comparative example was produced in the same manner as in the example, except that the Ar gas pressure during the sputtering of the Mo film on the substrate was 0.3 Pa.

### Observation of interface

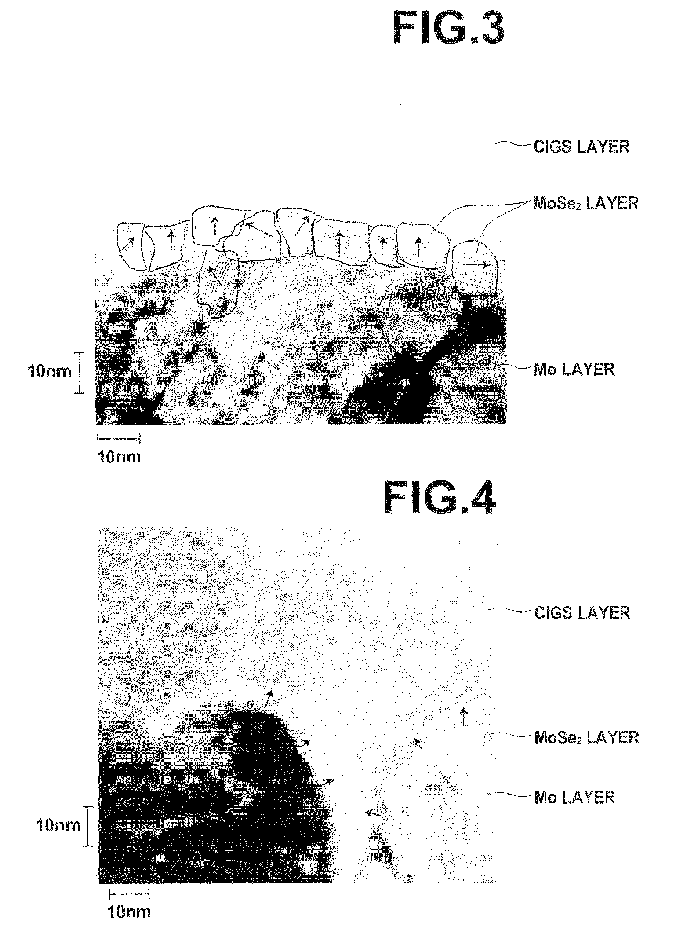

Cross sections of the samples produced according to the methods of the example and the comparative example were cut and the interface between the conductive layer and the CIGS layer of each sample was observed using a transmission electron microscope. FIG. 3 shows a transmission electron micrograph (TEM image) of the example and FIG. 4 shows a transmission electron micrograph of the comparative example. For ease of visual recognition of the layer structure (crystallites), auxiliary lines are provided in FIG. 3. The arrows provided in FIGS. 3 and 4 represent the c-axis directions.

As shown in FIGs. 3 and 4, it was confirmed that a MoSe₂ layer was formed at the interface between the Mo layer and the CIGS layer in both the samples.

Further, in the sample of the example shown in FIG. 3, the c-axes of the lot of crystallites formed on the Mo layer were oriented in various directions. In contrast, in the sample of the comparative example shown in FIG. 4, the c-axes along the surface of the Mo layer were oriented perpendicular to the surface on the columnar Mo layer, and a laminar MoSe₂ layer was uniformly formed on the surface of the Mo layer.

The ratio of the crystallites with the c-axes thereof perpendicular to the surface of the Mo layer relative to the number of the crystallites formed on the surface of the Mo layer of the sample of the example shown in FIG. 3 was found to be about 60%.

The ratio of the crystallites with the c-axes thereof perpendicular to the surface of the Mo layer relative to the number of the crystallites formed on the surface of the Mo layer was found in the following manner.

First, the sample produced according to the method of the example was sliced into a thin piece having a uniform thickness of 100 nm or less in the depth direction (the direction perpendicular to the observed cross section) by FIB machining to provide a sample for observation of the photoelectric conversion layer-back electrode interface area. Then, using this piece, a TEM image of a cross section of the layered films perpendicular to the substrate surface was taken by transmission electron microscopy. The observation of the image for evaluation was performed with a magnification of 2,000,000x. The field of view was at least 100 nm × 100 nm.

Utilizing the fact that the photoelectric conversion layer, the transition metal dichalcogenide thin film and the conductive layer are shown at different contrast levels in the taken image, and using a contrast adjusting function of an image processing software (PhotoShp®), only an area clearly distinguished as the transition metal dichalcogenide thin film was extracted.

An area of the extracted image of the particulates (crystallites) of the transition metal dichalcogenide was calculated from the number of pixels on the image processing software. The number of pixels of each particulate present in the field of view was calculated, and the ratio of crystallites with the c-axes thereof oriented in a substantially perpendicular direction relative to the whole area was calculated. At this time, crystallites with the c-axes thereof oriented at an angle in the range of 90°±10° relative to the Mo film were regarded as the crystallites with the c-axes thereof oriented in a substantially perpendicular direction.

### Cross cut test

Further, a cross cut test of the samples produced according to the methods of the example and the comparative example was performed based on the JIS standard (JIS-K5600). The cut interval was 1 mm, and the adhesion property was evaluated from delamination condition of 25 squares and cut crossings after an adhesion test. The number of delaminated squares was evaluated in percent, and was ranked according to the percentage from no delamination (100%) to full delamination (0%).

As a result of this test, the example was 100% and the comparative example was 0%.

As can be seen from the above-described results, when the MoSe₂ layer, which is a transition metal dichalcogenide, formed between the conductive layer and the CIGS layer includes a lot of crystallites and the ratio of crystallites with the c-axes thereof oriented perpendicular to the surface of the conductive layer is around 60%, as in the example, remarkable improvement of adhesion can be achieved when compared to the sample of the comparative example, where the laminar MoSe₂ layer was formed almost across the entire interface between the conductive layer and the CIGS layer.

## Claims

1. A photoelectric conversion device comprising, on a substrate, a layered structure of a conductive layer formed by a transition metal element, a photoelectric conversion layer formed by a compound semiconductor containing a group Ib element, a group IIIb element and a group VIb element, and a transparent electrode, the photoelectric conversion device further comprising:
a. transition metal dichalcogenide thin film formed by the transition metal element and the group VIb element between the conductive layer and the photoelectric conversion layer,
wherein the transition metal dichalcogenide thin film includes a lot of crystallites, and 80% or less of the lot of crystallites occupying the surface of the conductive layer, on which the thin film is formed, have c-axes thereof oriented substantially perpendicular to a surface of the conductive layer.

2. The photoelectric conversion device as claimed in claim 1, wherein the conductive layer is formed by an oriented polycrystalline thin film having a specific crystal plane at the surface thereof, and a plane spacing in the film thickness direction is not greater than a plane spacing of a bulk crystal.

3. The photoelectric conversion device as claimed in claim 2, wherein the specific crystal plane is (110).

4. The photoelectric conversion device as claimed in claim 1, wherein the conductive layer is formed by a thin film with at least part of the surface layer thereof including unoriented crystallites.

5. The photoelectric conversion device as claimed in claim 1, wherein at least part of the surface layer of the conductive layer is oxidized or nitrided.

6. The photoelectric conversion device as claimed in any one of claims 1 to 5, wherein the transition metal element is Mo.

7. The photoelectric conversion device as claimed in any one of claims 1 to 6, wherein
the group Ib element is Cu,
the group IIIb element is at least one selected from the group consisting of Al, Ga and In, and
the group VIb element is Se.

8. The photoelectric conversion device as claimed in any one of claims 1 to 7, wherein the transition metal dichalcogenide thin film is a MoSe₂ thin film.

9. The photoelectric conversion device as claimed in any one of claims 1 to 8, wherein the substrate is an anodized substrate selected from the group consisting of
an anodized substrate including an Al₂O₃ anodized film formed on at least one side of an Al base material,
an anodized substrate including an Al₂O₃ anodized film formed on at least one side of a composite base material formed by an Al material combined on at least one side of a Fe material, and
an anodized substrate including an Al₂O₃ anodized film formed on at least one side of a base material formed by an Al film formed on at least one side of a Fe material.
